# EUROPEAN PATENT APPLICATION

(11) **EP 4 831 972 A1**
(43) Date of publication of application: **28.10.2026**
(21) Application number: 24907871.8
(22) Date of filing: 29.11.2024
(51) Int. Cl.: G09G 3/00, G09G 3/3275, H10K 59/131

(54) **DISPLAY DEVICE**

(30) Priority: 21.12.2023 KR 20230188340
(71) Applicant: Samsung Display Co., Ltd., Yongin-si, Gyeonggi-do 17113 (KR)
(72) Inventor: SEO, Young Wan, Yongin-si Gyeonggi-do 17113 (KR); PARK, Jun Hyun, Yongin-si Gyeonggi-do 17113 (KR)
(74) Representative: Marks & Clerk LLP
(86) International application number: PCT/KR2024/019360
(87) International publication number: WO 2025/135586

(57) **Abstract**

According to an embodiment of the disclosure, a display device comprising a plurality of pixels arranged in a display area of a display panel, a test switching element area formed in a non-display area or a sub-area of the display panel and including a plurality of test switching elements, and a display driving circuit controlling supply timings of data voltages and driving control signals supplied to the plurality of pixels, wherein the display driving circuit controls turn-off switching operations of the plurality of test switching elements so that the plurality of test switching elements are maintained in a turn-off state during an image display period.

## Description

### [Technical Field]

The present disclosure relates to a display device.

### [Background of the Invention]

As the information society develops, the demand for display devices for displaying images has increased and diversified. For example, display devices have been applied to various electronic devices such as smartphones, digital cameras, laptop computers, navigation devices, and smart televisions.

The display devices may be flat panel display devices such as liquid crystal display devices, field emission display devices, or organic light emitting display devices. Among such flat panel display devices, a light emitting display device may display an image without a backlight unit providing light to a display panel because each of pixels of the display panel includes light emitting elements that may emit light by themselves.

The display panel is manufactured by forming pixels, driving circuits, and the like, according to resolution in cell regions of a mother glass, separating the respective cell regions, and modularizing the separated cell regions into display panels. Before each display panel is commercialized, test data voltages and scan signals are supplied to all pixels using test switching elements formed on the display panel, and light emitting states, defects, and the like, of the pixels are tested.

### [Summary of the Invention]

### [Aspects to be Achieved by the Invention]

Aspects of the present disclosure provide a display device whose design is changed so that test switching elements formed on a display panel are stably maintained in a turn-off state even after the display panel is commercialized.

Aspects of the present disclosure also provide a display device capable of controlling test switching elements of a display panel to be stably maintained in a turn-off state.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [Means for Achieving the Aspects of the Invention]

According to an embodiment of the disclosure, a display device comprising a plurality of pixels arranged in a display area of a display panel, a test switching element area formed in a non-display area or a sub-area of the display panel and including a plurality of test switching elements, and a display driving circuit controlling supply timings of data voltages and driving control signals supplied to the plurality of pixels, wherein the display driving circuit controls turn-off switching operations of the plurality of test switching elements so that the plurality of test switching elements are maintained in a turn-off state during an image display period.

In an embodiment, the plurality of test switching elements are connected to a plurality of data lines formed in the display area or a plurality of fan-out lines formed in the non-display area in a one-to-one manner in parallel structures with the plurality of data lines or the plurality of fan-out lines.

In an embodiment, the plurality of test switching elements are connected to a plurality of gate lines formed in the display area or a plurality of power lines extending to the non-display area in a one-to-one manner in parallel structures with the plurality of gate lines or the plurality of power lines.

According to an embodiment of the disclosure, a display device comprising a plurality of pixels arranged in a display area of a display panel, a gate driver supplying scan signals to gate lines arranged in a non-display area and the display area of the display panel, a test switching element area formed in the non-display area or a sub-area of the display panel and including a plurality of test switching elements, and a display driving circuit controlling supply timings of data voltages and driving control signals supplied to the plurality of pixels and gate control signals supplied to the gate driver, wherein the display driving circuit controls turn-off switching operations of the plurality of test switching elements so that the plurality of test switching elements are maintained in a turn-off state during an image display period.

In an embodiment, the plurality of test switching elements are connected to a plurality of data lines formed in the display area or a plurality of fan-out lines formed in the non-display area in a one-to-one manner in parallel structures with the plurality of data lines or the plurality of fan-out lines.

In an embodiment, the plurality of test switching elements are connected to a plurality of gate lines formed in the display area or a plurality of power lines extending to the non-display area in a one-to-one manner in parallel structures with the plurality of gate lines or the plurality of power lines.

### [Effects of the Invention]

A display device according to an embodiment of the present disclosure may prevent current and voltage leakage of lines and pixels of a display panel by changing a design so that test switching elements formed on the display panel are stably maintained in a turn-off state even after the display panel is commercialized.

In addition, the display device according to an embodiment of the present disclosure may prevent an image display defect due to voltage and current leakage and increase reliability of a product by controlling the test switching elements of the display panel to be stably maintained in the turn-off state.

The effects of the present disclosure are not limited to the aforementioned effects, and various other effects are included in the present specification.

### [Brief Description of the Drawings]

FIG. 1 is a perspective view illustrating a display device according to a first embodiment;
FIG. 2 is a plan view illustrating the display device according to a first embodiment;
FIG. 3 is a plan view illustrating a display device according to a second embodiment;
FIG. 4 is a side view illustrating the display device according to first and second embodiments;
FIG. 5 is a schematic layout diagram illustrating an example of a display panel according to a first embodiment illustrated in FIGS. 1 and 2;
FIG. 6 is a schematic layout diagram illustrating an example of a display panel according to a second embodiment illustrated in FIG. 3;
FIG. 7 is a schematic circuit diagram of a first embodiment illustrating test switching elements formed in a test switching element area;
FIG. 8 is a waveform diagram illustrating switching control signals supplied to the test switching elements of FIG. 7 and changes in voltage magnitude of data lines;
FIG. 9 is a schematic circuit diagram of a second embodiment illustrating test switching elements formed in a test switching element area;
FIG. 10 is a waveform diagram illustrating switching control signals supplied to the test switching elements of FIG. 9 and changes in voltage magnitude of data lines;
FIG. 11 is a schematic circuit diagram of a third embodiment illustrating test switching elements formed in a test switching element area;
FIG. 12 is a waveform diagram illustrating switching control signals supplied to the test switching elements of FIG. 11 and changes in voltage magnitude of data lines;
FIGS. 13 and 14 are perspective views illustrating a display device according to another embodiment of the present disclosure; and
FIGS. 15 and 16 are perspective views illustrating a display device according to still another embodiment of the present disclosure.

### [Detailed Description of the Preferred Embodiments]

The present disclosure will now be described more fully hereinafter with reference to the accompanying drawings, in which preferred embodiments of the disclosure are shown. This disclosure may, however, be embodied in different forms and should not be construed as limited to the embodiments set forth herein. Rather, these embodiments are provided so that this disclosure will be thorough and complete, and will filly convey the scope of the disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, specific embodiments will be described with reference to the accompanying drawings.

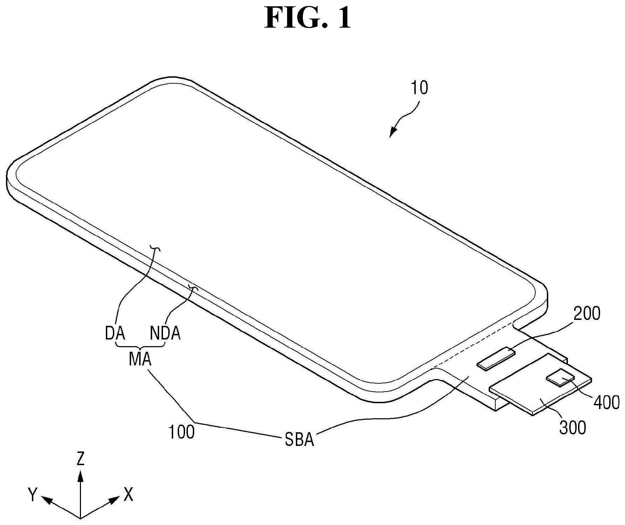

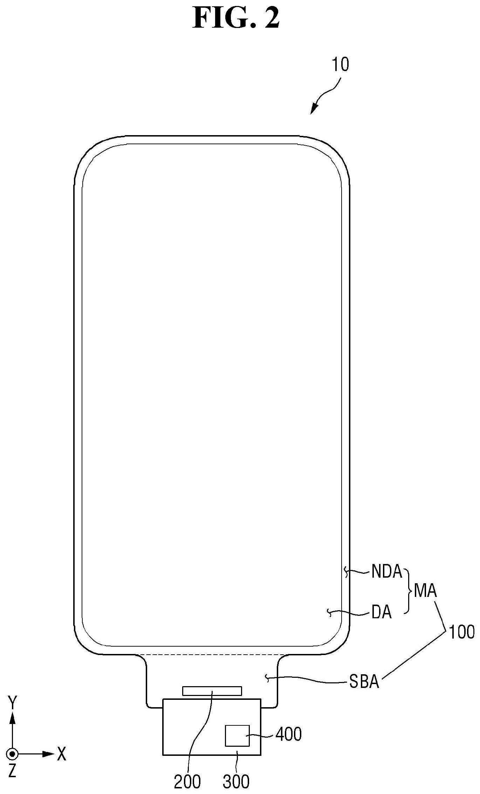

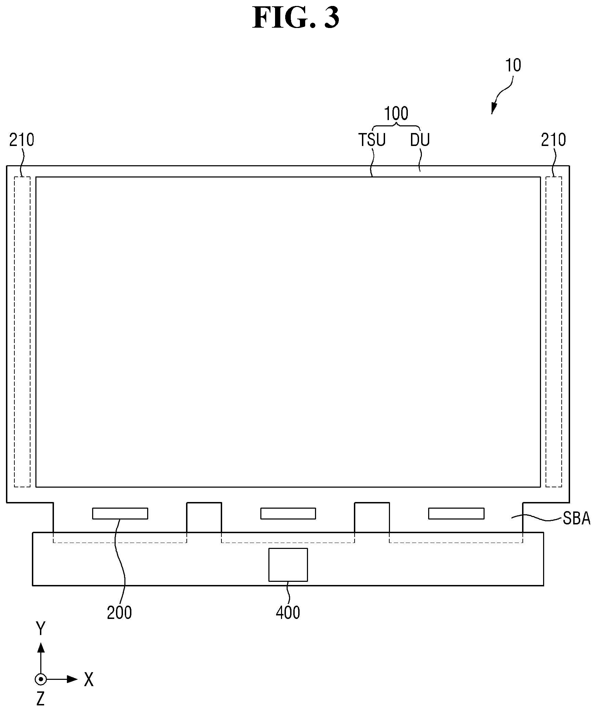

FIG. 1 is a perspective view illustrating a display device according to a first embodiment, and FIG. 2 is a plan view illustrating the display device according to a first embodiment. In addition, FIG. 3 is a plan view illustrating a display device according to a second embodiment.

Referring to FIGS. 1 and 2, a display device 10 according to an embodiment may be applied to portable electronic devices such as mobile phones, smartphones, tablet personal computers (PCs), mobile communication terminals, electronic notebooks, electronic books, portable multimedia players (PMPs), navigation devices, and ultra mobile PCs (UMPCs). In addition, the display device 10 according to an embodiment may be applied to wearable devices such as smart watches, watch phones, glasses-type displays, and head mounted displays (HMDs).

In addition, referring to FIG. 3, the display device 10 according to an embodiment may be applied to portable electronic devices such as mobile phones, smartphones, tablet PCs, mobile communication terminals, electronic notebooks, electronic books, PMPs, navigation devices, and UMPCs. In addition, the display device 10 according to an embodiment may be applied to a center information display (CID) disposed on an instrument board, a center fascia, or a dashboard of a vehicle, a room mirror display substituting for a side-view mirror of the vehicle, or a display disposed on a rear surface of a front seat as entertainment for a rear seat of the vehicle.

The display device 10 according to an embodiment may be variously classified according to a display method. For example, the display device 10 may be a light emitting display device such as an organic light emitting display device using organic light emitting diodes, a quantum dot light emitting display device including quantum dot light emitting layers, an inorganic light emitting display device including inorganic semiconductors, and a micro light emitting display device using micro or nano light emitting diodes (micro LEDs or nano LEDs). Hereinafter, it is mainly described that the display device 10 according to an embodiment is an organic light emitting display device, but the display device 10 is not limited to the organic light emitting display device, and may be other display devices mentioned above or well-known in the art without departing from the technical idea.

The display device 10 according to an embodiment includes a display panel 100, a display driving circuit 200, a circuit board 300, and a touch driving circuit 400.

The display panel 100 may be formed in a rectangular shape, in plan view, having short sides in a first direction (X-axis direction) and long sides in a second direction (Y-axis direction) crossing the first direction (X-axis direction). A corner where the short side in the first direction (X-axis direction) and the long side in the second direction (Y-axis direction) meet may be rounded with a predetermined curvature or right-angled. A shape of the display panel 100 in plan view is not limited to the rectangular shape, and may be other polygonal shapes, a circular shape, or an elliptical shape. The display panel 100 may be formed to be flat, but is not limited thereto. For example, the display panel 100 includes curved surface portions formed at left and right ends thereof and having a constant curvature or a variable curvature. In addition, the display panel 100 may be flexibly formed to be curved, bent, folded, or rolled.

The display panel 100 includes a main area MA and a sub-area SBA.

The main area MA includes a display area DA displaying an image and a non-display area NDA, which is a peripheral area of the display area DA. The display area DA includes pixels displaying an image. The non-display area NDA may be a peripheral area of the display area DA, that is, an area outside the display area DA. The non-display area NDA may be defined as an edge area of the main area MA corresponding to the display area DA of the display panel 100. As illustrated in FIG. 3, the non-display area NDA may include at least one gate driver 210 supplying gate signals to gate lines and fan-out lines (not illustrated) connecting the display driving circuit 200 and the display area DA to each other.

The sub-area SBA may protrude and extend from one side of the main area MA in the second direction (Y-axis direction). The sub-area SBA may include a flexible material that may be bent, folded, and rolled. The sub-area SBA may include the display driving circuit 200 and pad parts connected to the circuit board 300. Alternatively, the sub-area SBA may be omitted, and the display driving circuit 200 and the pad parts may be disposed in the non-display area NDA.

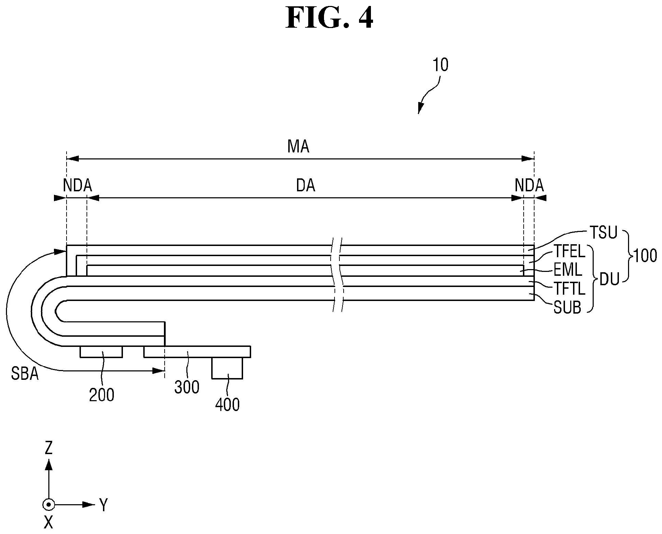

FIG. 4 is a side view illustrating the display device according to first and second embodiments.

It has been illustrated in FIGS. 1 to 3 that the sub-area SBA is unbent, but the sub-area SBA may be bent as illustrated in FIG. 4, and when the sub-area SBA is bent, the sub-area SBA may be disposed in a rear surface direction of the display panel 100. In other words, when the sub-area SBA is bent, the sub-area SBA may overlap a substrate SUB in a thickness direction (Z-axis direction). The display driving circuit 200 may be disposed in the sub-area SBA.

In addition, the display panel 100 includes a display module DU including a substrate SUB, a thin film transistor layer TFTL, a light emitting element layer EML, and an encapsulation layer TFEL, and a touch sensing unit TSU formed on a front surface of the display module DU.

The substrate SUB may be a base substrate or a base member. The substrate SUB may be a flat-type substrate. Alternatively, the substrate SUB may be a flexible substrate that may be bent, folded, and rolled.

The thin film transistor layer TFTL is disposed on the substrate SUB. The thin film transistor layer TFTL may include a plurality of thin film transistors constituting a pixel circuit of each of the pixels. The thin film transistor layer TFTL may further include gate lines, data lines, power lines, gate control lines, fan-out lines connecting the display driving circuit 400 and the data lines to each other, and lead lines connecting the display driving circuit 400 and the pad parts to each other. When the gate drivers 210 are formed on one side and the other side of the non-display area NDA of the display panel 100, respectively, the respective gate drivers 210 may also include thin film transistors.

The thin film transistor layer TFTL may be selectively disposed in the display area DA, the non-display area NDA, and the sub-area SBA. The thin film transistors of each of the pixels, the gate lines, the data lines, and the power lines of the thin film transistor layer TFTL may be disposed in the display area DA. The gate control lines and the fan-out lines of the thin film transistor layer TFTL may be disposed in the non-display area NDA.

The light emitting element layer EML may be disposed on the thin film transistor layer TFTL. The light emitting element layer EML may include a plurality of light emitting elements in which a first electrode, a light emitting layer, and a second electrode are sequentially stacked to emit light and a pixel defining film defining the respective pixels. The light emitting element layer EML may be disposed in the display area DA of the main area MA.

The encapsulation layer TFEL may cover an upper surface and side surfaces of the light emitting element layer EML, and may protect the light emitting element layer EML. The encapsulation layer TFEL may be disposed in the display area DA and the non-display area NDA of the main area MA. The encapsulation layer TFEL includes at least one inorganic layer and at least one organic layer for encapsulating the light emitting element layer.

The touch sensing unit TSU may be formed on the encapsulation layer TFEL or mounted on the encapsulation layer TFEL. The touch sensing unit TSU may be disposed on the display area DA of the main area MA. The touch sensing unit TSU may sense a touch of a person or an object using touch electrodes. In the touch sensing unit TSU, the touch electrodes may be arranged in a matrix structure to sense a user's touch using a self-capacitance manner or a mutual capacitance manner.

The touch sensing unit TSU may not be formed integrally with the display panel 100, and may be disposed on a separate substrate or film disposed on the display module DU of the display panel 100. In this case, the substrate or the film supporting the touch sensing unit TSU may be a base member encapsulating the display module DU.

A cover window for protecting an upper portion of the display panel 100 may be disposed on the touch sensing unit TSU. The cover window may be attached onto the touch sensing unit TSU by a transparent adhesive member such as an optically clear adhesive (OCA) film or an optically clear resin (OCR). The cover window may be made of an inorganic material such as glass or be made of an organic material such as plastic or a polymer material. In order to prevent deterioration of visibility of an image due to external light reflection, a polarizing layer may be additionally disposed between the touch sensing unit TSU and the cover window.

The display driving circuit 200 may generate signals and voltages for driving the display panel 100. The display driving circuit 200 may be formed as an integrated circuit (IC) and attached onto the display panel 100 in a chip on glass (COG) manner, a chip on plastic (COP) manner, or an ultrasonic bonding manner, but is not limited thereto. For example, the display driving circuit 200 may be attached onto the circuit board 300 in a chip on film (COF) manner.

The circuit board 300 may be attached to one end of the sub-area SBA of the display panel 100. For this reason, the circuit board 300 may be electrically connected to the display panel 100 and the display driving circuit 200. The display panel 100 and the display driving circuit 200 may receive digital video data, timing signals, and driving voltages through the circuit board 300. The circuit board 300 may be a flexible printed circuit board, a printed circuit board, or a flexible film such as a chip on film.

The touch driving circuit 400 may be disposed on the circuit board 300. The touch driving circuit 400 may be formed as an integrated circuit (IC) and attached to the circuit board 300.

The touch driving circuit 400 may be electrically connected to the touch electrodes of the touch sensing unit TSU. The touch driving circuit 400 applies touch driving signals to the touch electrodes of the touch sensing unit TSU, and measures a charge change amount in mutual capacitance of each of a plurality of touch nodes formed by the touch electrodes. Specifically, the touch driving circuit 400 measures changes in capacitance of the plurality of touch nodes according to changes in voltage magnitude or current amount of touch sensing signals received through the touch electrodes. In this way, the touch driving circuit 400 may decide whether or not a user has touched the display device, whether or not the user has approached the display device, and the like, according to the charge change amount in the mutual capacitance of each of the plurality of touch nodes. The touch of the user indicates that a user's finger or an object such as a pen comes into direct contact with one surface of the cover window disposed on the touch sensing unit TSU. The approach of the user indicates that the user's finger or the object such as the pen hovers above one surface of the cover window with a predetermined interval from one surface of the cover window.

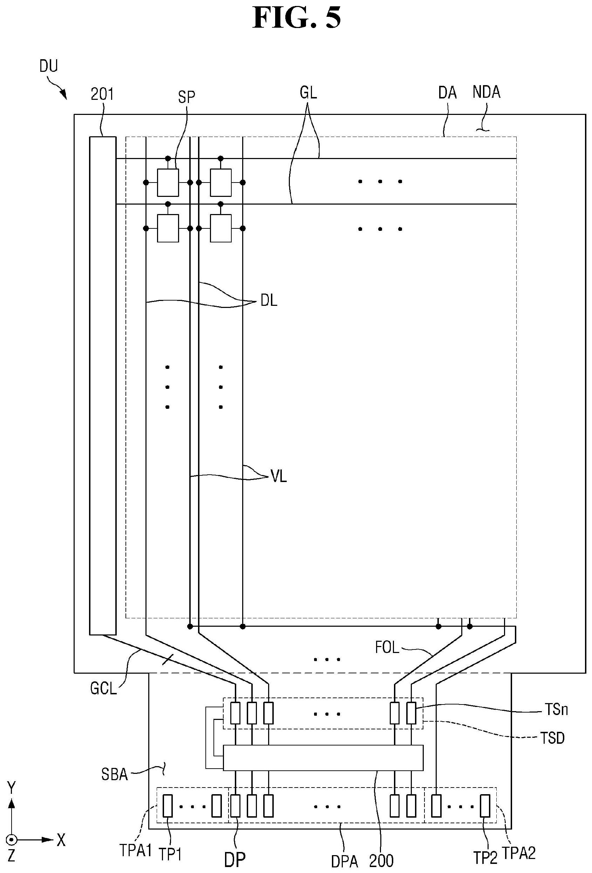

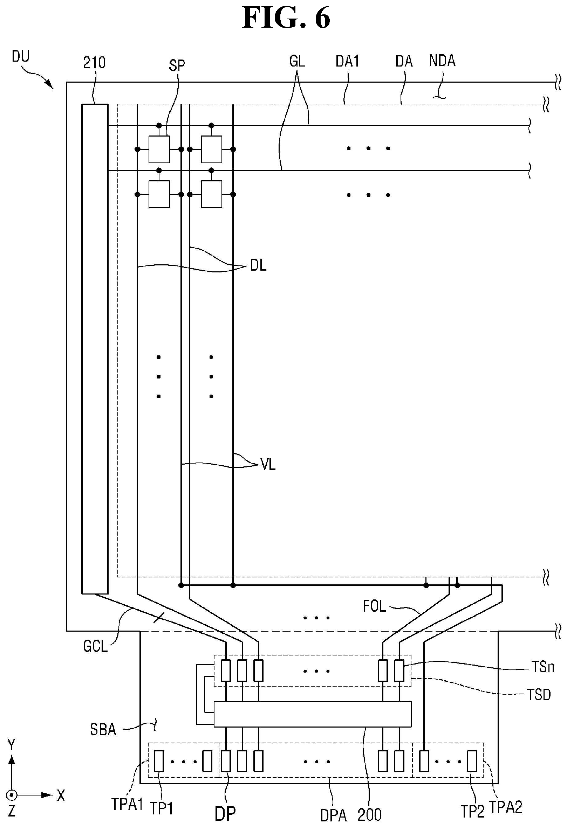

FIG. 5 is a schematic layout diagram illustrating an example of a display panel according to a first embodiment illustrated in FIGS. 1 and 2. In addition, FIG. 6 is a schematic layout diagram illustrating an example of a display panel according to a second embodiment illustrated in FIG. 3. Specifically, FIGS. 5 and 6 are layout diagrams illustrating a display area DA and a non-display area NDA of the display module DU in a state before the touch sensing unit TSU is formed.

The display area DA is an area displaying an image, and may be defined as a central area of the display panel 100. The display area DA may include a plurality of pixels SP, a plurality of gate lines GL, a plurality of data lines DL, and a plurality of power lines VL. Each of the plurality of pixels SP may be defined as a minimum unit outputting light.

The plurality of gate lines GL may supply gate signals, for example, scan signals, received from the gate driver 201 to the plurality of pixels SP. The plurality of gate lines GL may extend in the X-axis direction and may be spaced apart from each other in the Y-axis direction crossing the X-axis direction.

The plurality of data lines DL may supply data voltages received from the display driving circuit 200 to the plurality of pixels SP. The plurality of data lines DL may extend in the Y-axis direction and may be spaced apart from each other in the X-axis direction.

The plurality of power lines VL may supply source voltages received from the display driving circuit 200 to the plurality of pixels SP. Here, the source voltage may be at least one of a driving voltage, an initialization voltage, and a reference voltage. The plurality of power lines VL may extend in the Y-axis direction and may be spaced apart from each other in the X-axis direction.

The non-display areas NDA may surround the display area DA. The non-display area NDA may include the gate driver 201, fan-out lines FOL, and gate control lines GCL. The gate driver 201 may generate a plurality of gate signals based on gate control signals, and may sequentially supply the plurality of gate signals to the plurality of gate lines GL according to a set order.

The fan-out lines FOL may extend from the display driving circuit 200 to the display area DA. The fan-out lines FOL may supply the data voltages received from the display driving circuit 200 to the plurality of data lines DL.

The gate control lines GCL may extend from the display driving circuit 200 to the gate driver 201. The gate control lines GCL may supply the gate control signals received from the display driving circuit 200 to the gate driver 201.

The sub-area SBA may include the display driving circuit 200, a display pad area DPA, and first and second touch pad areas TPA1 and TPA2. The display pad area DPA may include at least one display pad (DP). The first and second touch pad areas TPA1 and TPA2 may each include at least one first touch pad TP1 and at least one second touch pad TP2.

The display driving circuit 200 may output signals and voltages for driving the display panel 100 to the fan-out lines FOL. The display driving circuit 200 may supply the data voltages to the data lines DL through the fan-out lines FOL. The data voltages may be supplied to the plurality of pixels SP, and may determine luminance of the plurality of pixels SP. The display driving circuit 200 may supply the gate control signals to the gate driver 201 through the gate control lines GCL.

The display pad area DPA, the first touch pad area TPA1, and the second touch pad area TPA2 may be disposed at an edge of the sub-area SBA. The display pad area DPA, the first touch pad area TPA1, and the second touch pad area TPA2 may be electrically connected to the circuit board 300 using a low-resistance and high-reliability material such as an anisotropic conductive layer or a self assembly anisotropic conductive paste (SAP).

The display pad area DPA may include a plurality of display pad parts. The plurality of display pad parts may be connected to the display driving circuit 200 or the touch driving circuit 400 through the circuit board 300. The plurality of display pad parts may be connected to the circuit board 300 to receive digital video data, and may supply the digital video data to the display driving circuit 200.

A test switching element area TSD formed and used in order to test the display panel 100 before the display panel 100 is commercialized is included in the non-display area NDA or the sub-area SBA of the display panel 100.

A plurality of test switching elements TSn electrically connected respectively to the plurality of data lines DL formed in the display area DA or the non-display area NDA or the fan-out lines FOL connected to the plurality of data lines DL are disposed in the test switching element area TSD.

In addition, test switching elements electrically connected respectively to the plurality of gate lines GL and the power lines VL formed in the display area DA or the non-display area NDA may be further formed in the test switching element area TSD. Such test switching elements TSn formed in the test switching element area TSD may be connected to at least one of the plurality of data lines DL or the fan-out lines FOL, the plurality of gate lines GL, and the power lines VL formed in the display area DA or the non-display area NDA in a one-to-one manner.

As described above, in a test step before the display panel 100 is commercialized, a test device turns on the test switching elements TSn formed in the non-display area NDA or the sub-area SBA of the display panel 100, and supplies scan voltages to the gate lines GL through the test switching elements TSn. Alternatively, the test device may also supply the gate control signals to the gate driver 210. In addition, the test device also supplies high-potential and low-potential driving voltages to the power line VL, respectively. In addition, the test device also turns on the test switching elements TSn connected respectively to the plurality of data lines DL or the fan-out lines FOL, and supplies test data voltages to the data lines DL through the test switching elements TSn to allow all pixels SP to emit light.

After a good product is decided through a test, the display driving circuit 200 is mounted in the non-display area NDA, the sub-area SBA, or the like, of the display panel 100, and the circuit board 300, the touch driving circuit 400, and the like, are placed.

The display driving circuit 200 controls turn-off switching operations of the test switching elements TSn so that all of the test switching elements TSn are maintained in a turn-off state in a commercialized state of the display panel 100 in which the display driving circuit 200, the touch driving circuit 400, and the like, are formed. That is, in a power-off state of the display panel 100 as well as the display device 10, all of the test switching elements TSn are also in a turn-off state. On the other hand, when the display panel 100 as well as the display device 10 is turned on, the display driving circuit 200 supplies the gate control signals to the gate driver 210 and supplies the data voltages to the fan-out lines POL to drive all pixels SP. That is, during an image display period in which the display device 10 is turned on, the display driving circuit 200 drives all pixels SP to display an image in the display area DA. Meanwhile, during such an image display period, the display driving circuit 200 controls the turn-off switching operations of the test switching elements TSn to maintain all of the test switching elements TSn in a stable turn-off state.

All of the test switching elements TSn are in a state in which they are electrically connected to the data lines DL, the power lines DL, or the gate lines GL, and may thus be electrically affected by changes in voltage and current of the lines to which they are connected, respectively. Accordingly, when all of the test switching elements TSn are not maintained in the stable turn-off state, a problem such as leakage of a voltage or a current through the test switching elements TSn may occur. Accordingly, the display driving circuit 200 should control the turn-off switching operations of the test switching elements TSn so that the test switching elements TSn are more stably maintained in the turn-off even though the test switching elements TSn are electrically affected by specific lines, respectively.

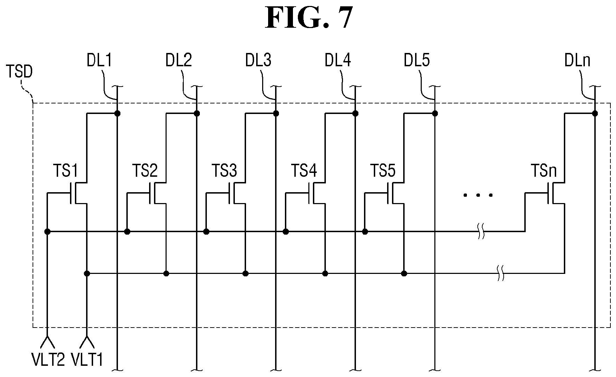

FIG. 7 is a schematic circuit diagram of a first embodiment illustrating test switching elements formed in a test switching element area.

Referring to FIG. 7, first to n-th test switching elements TS1 to TSn connected to first to n-th data lines DL1 to DLn extending to the display area DA or the non-display area NDA in a one-to-one manner are disposed in the test switching element area TSD. Here, n is a positive integer excluding 0.

As described above, the test switching elements TSn in the test switching element area TSD may be connected to at least one of the fan-out lines FOL, the plurality of gate lines GL, and the power lines VL extending to the display area DA or the non-display area NDA in a one-to-one manner. However, hereinafter, for convenience of detailed explanation, an example in which the test switching elements TSn are connected to the data lines DL in a one-to-one manner will be described.

The first to n-th test switching elements TS1 to TSn are electrically connected to the first to n-th data lines DL1 to DLn, respectively, in parallel structures with the first to n-th data lines DL1 to DLn. The first to n-th test switching elements TS1 to TSn may be formed as thin film transistors such as metal oxide semiconductor field effect transistors (MOSFETs).

First electrodes of the first to n-th test switching elements TS1 to TSn are connected to the first to n-th data lines DL1 to DLn in a one-to-one manner, and second electrodes of the first to n-th test switching elements TS1 to TSn are connected to a first line terminal VLT1 to which a test direct current (DC) voltage (or a test data voltage) or a first off control signal (for example, a first gate-off voltage) is supplied. In addition, gate electrodes of the first to n-th test switching elements TS1 to TSn are connected to a second line terminal VLT2 to which a gate-on signal or a second off control signal (e.g., a second gate-off voltage) is supplied.

The first to n-th test switching elements TS1 to TSn may be formed as N-type NMOSFETs, and the first electrode of each of the first to n-th test switching elements TS1 to TSn may be a drain electrode and the second electrode of each of the first to n-th test switching elements TS1 to TSn may be a source electrode.

During a test period of the display panel 100, the first to n-th test switching elements TS1 to TSn may be turned on in response to the gate-on signal input to the respective gate electrodes, and may supply the test DC voltage input to the second electrodes to the respective data lines DL1 to DLn to which the first electrodes are connected.

On the other hand, during an image display period in a state in which the display panel 10 is commercialized, the first to n-th test switching elements TS1 to TSn are maintained in a turn-off state by the second off control signal (e.g., the second gate-off control signal) input to the respective gate electrodes. In this case, the first off control signal (e.g., the first gate-off voltage) may be supplied to the first electrodes. The first to n-th test switching elements TS1 to TSn may be maintained in the stable turn-off state so that data voltages of the data lines DL1 to DLn are not leaked even though magnitudes of the data voltages of the data lines DL1 to DLn respectively connected to the first electrodes are changed.

Meanwhile, when the first to n-th test switching elements TS1 to TSn are connected to the respective gate lines GL and power lines VL, the first electrodes of the first to n-th test switching elements TS1 to TSn may be connected to the respective gate lines GL and power lines VL in a one-to-one manner. In this case, the second electrodes of the first to n-th test switching elements TS1 to TSn may be connected to the first line terminal VLT1 to which a scan voltage or the first off control signal (e.g., the first gate-off voltage) is supplied. In addition, the gate electrodes of the first to n-th test switching elements TS1 to TSn may be connected to the second line terminal VLT2 to which the gate-on signal or the second off control signal (e.g., the second gate-off voltage) is supplied.

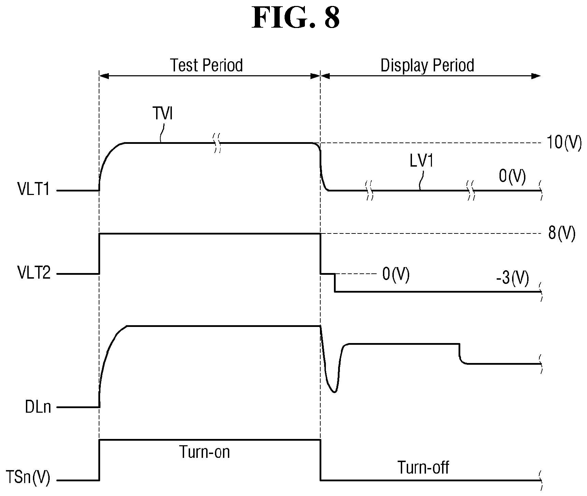

FIG. 8 is a waveform diagram illustrating switching control signals supplied to the test switching elements of FIG. 7 and changes in voltage magnitude of data lines.

Referring to FIG. 8, in a test period before the display panel 100 is commercialized, the test device supplies a test DC voltage TVI (e.g., a test data voltage of 10 V) to the second electrodes of the first to n-th test switching elements TS1 to TSn through the first line terminal VLT1 of the display panel 100. In addition, the test device supplies a gate-on signal (e.g., a DC voltage of 8 V) to the gate electrodes of the first to n-th test switching elements TS1 to TSn through the second line terminal VLT2 of the display panel 100.

The first to n-th test switching elements TS1 to TSn may be turned on by the gate-on signal supplied to the gate electrodes, and may supply the test DC voltage TVI input to the second electrodes to the respective data lines DL1 to DLn to which the first electrodes are connected.

Thereafter, during a period when the display panel 100 is commercialized and displays an image, the display driving circuit 200 may maintain the second electrodes of the first to n-th test switching elements TS1 to TS1 in a floating state (e.g., a state of 0 V) through the first line terminal VLT1 of the display panel 100 or supply a first off control signal LV1 (e.g., a first gate-off voltage of 0 V) to the first line terminal VLT1. In addition, the display driving circuit 200 turns off the first to n-th test switching elements TS1 to TSn by supplying a second off control signal (e.g., a second gate-off voltage of -3 V) to the gate electrodes of the first to n-th test switching elements TS1 to TSn through the second line terminal VLT2 of the display panel 100.

During an image display period, the display driving circuit 200 supplies data voltages for image display to the respective data lines DL1 to DLn connected to the first to n-th test switching elements TS1 to TSn in parallel in units of at least one frame period.

During the image display period, the display driving circuit 200 may supply the second off control signal (e.g., the second gate-off voltage of -3 V) having a lower voltage magnitude than the first off control signal (e.g., the first gate-off voltage of 0 V) to the gate electrodes of the first to n-th test switching elements TS1 to TSn.

The display driving circuit 200 may maintain all of the test switching elements TSn in the stable turn-off state by controlling the turn-off switching operations of the test switching elements TSn using the second off control signal (e.g., the second gate-off voltage of -3 V) having the lower voltage magnitude than the first off control signal (e.g., the first gate-off voltage of 0 V) during the image display period.

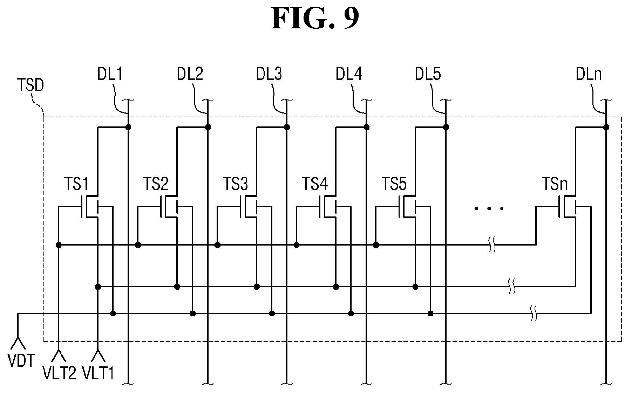

FIG. 9 is a schematic circuit diagram of a second embodiment illustrating test switching elements formed in a test switching element area.

As described above, the test switching elements TSn in the test switching element area TSD may be connected to at least one of the fan-out lines FOL, the plurality of gate lines GL, and the power lines VL extending to the display area DA or the non-display area NDA in a one-to-one manner. In addition, as illustrated in FIG. 9, first to n-th test switching elements TS1 to TSn connected to first to n-th data lines DL1 to DLn extending to the display area DA or the non-display area NDA in a one-to-one manner may be disposed in the test switching element area TSD.

Referring to FIG. 9, first electrodes of the first to n-th test switching elements TS1 to TSn are connected to the first to n-th data lines DL1 to DLn in a one-to-one manner, and second electrodes of the first to n-th test switching elements TS1 to TSn are connected to a first line terminal VLT1 to which a test DC voltage (or a test data voltage) or a first off control signal (for example, a first gate-off voltage) is supplied.

First and second gate electrodes of the first to n-th test switching elements TS1 to TSn may be formed as double layers by overlapping each other with at least one interlayer insulating layer interposed therebetween. Accordingly, the first gate electrodes of the first to n-th test switching elements TS1 to TSn are connected to a second line terminal VLT2 to which a gate-on signal or a second off control signal (e.g., a second gate-off voltage) is supplied. In addition, the second gate electrodes of the first to n-th test switching elements TS1 to TSn are connected to a DC voltage line terminal VDT to which a third off control signal (e.g., a third gate-off voltage) having a preset DC voltage magnitude is supplied.

Meanwhile, when the first to n-th test switching elements TS1 to TSn are connected to the respective gate lines GL and power lines VL, the first electrodes of the first to n-th test switching elements TS1 to TSn may be connected to the respective gate lines GL and power lines VL in a one-to-one manner. In this case, the second electrodes of the first to n-th test switching elements TS1 to TSn may be connected to the first line terminal VLT1 to which a test scan voltage or the first off control signal (e.g., the first gate-off voltage) is supplied. In addition, the first gate electrodes of the first to n-th test switching elements TS1 to TSn may be connected to the second line terminal VLT2 to which the gate-on signal or the second off control signal (e.g., the second gate-off voltage) is supplied. In addition, the second gate electrodes of the first to n-th test switching elements TS1 to TSn are connected to the DC voltage line terminal VDT to which the third off control signal (e.g., the third gate-off voltage) having the preset DC voltage magnitude is supplied.

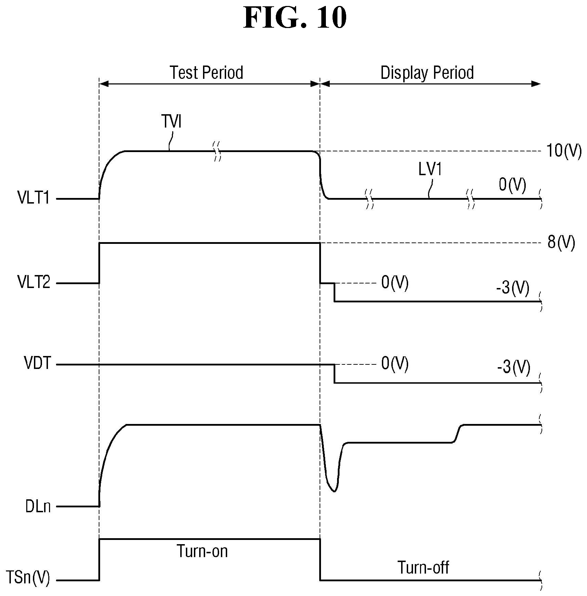

FIG. 10 is a waveform diagram illustrating switching control signals supplied to the test switching elements of FIG. 9 and changes in voltage magnitude of data lines.

Referring to FIG. 10, in a test period before the display panel 100 is commercialized, the test device supplies a test DC voltage TVI (e.g., a test data voltage of 10 V) to the second electrodes of the first to n-th test switching elements TS1 to TSn through the first line terminal VLT1 of the display panel 100. In addition, the test device supplies a gate-on signal (e.g., a DC voltage of 8 V) to the first gate electrodes of the first to n-th test switching elements TS1 to TSn through the second line terminal VLT2 of the display panel 100.

The first to n-th test switching elements TS1 to TSn may be turned on by the gate-on signal supplied to the first gate electrodes, and may supply the test DC voltage TVI input to the second electrodes to the respective data lines DL1 to DLn to which the first electrodes are connected. A DC voltage having a preset magnitude of about 0 V may be supplied to the second gate electrodes of the first to n-th test switching elements TS1 to TSn through the DC voltage line terminal VDT.

During a period when the display panel 100 is commercialized and displays an image, the display driving circuit 200 may maintain the second electrodes of the first to n-th test switching elements TS1 to TS1 in a floating state (e.g., a state of 0 V) through the first line terminal VLT1 of the display panel 100 or supply a first off control signal LV1 (e.g., a first gate-off voltage of 0 V) to the first line terminal VLT1.

The display driving circuit 200 turns off the first to n-th test switching elements TS1 to TSn by supplying a second off control signal (e.g., a second gate-off voltage of -3 V) to the first gate electrodes of the first to n-th test switching elements TS1 to TSn through the second line terminal VLT2 of the display panel 100. Particularly, the display driving circuit 200 may supply the second off control signal (e.g., the second gate-off voltage of -3 V) having a lower voltage magnitude than the first off control signal (e.g., the first gate-off voltage of 0 V) to the first gate electrodes of the first to n-th test switching elements TS1 to TSn.

In addition, the display driving circuit 200 may stably maintain voltage fluctuations of the first and second gate electrodes by supplying a third off control signal (for example, a third gate-off voltage of 3V) having a preset DC voltage magnitude to the second gate electrodes of the first to n-th test switching elements TS1 to TSn.

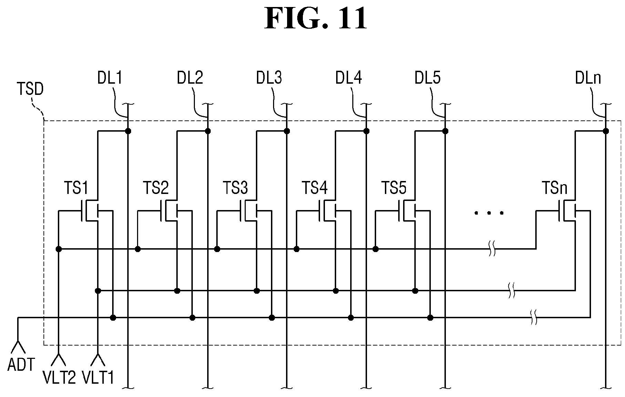

FIG. 11 is a schematic circuit diagram of a third embodiment illustrating test switching elements formed in a test switching element area.

Referring to FIG. 11, first electrodes of first to n-th test switching elements TS1 to TSn are connected to first to n-th data lines DL1 to DLn in a one-to-one manner, and second electrodes of the first to n-th test switching elements TS1 to TSn are connected to a first line terminal VLT1 to which a test DC voltage (or a test data voltage) or a first off control signal (for example, a first gate-off voltage) is supplied.

First and second gate electrodes of the first to n-th test switching elements TS1 to TSn may be formed as double layers by overlapping each other with at least one interlayer insulating layer interposed therebetween. Accordingly, the first gate electrodes of the first to n-th test switching elements TS1 to TSn are connected to a second line terminal VLT2 to which a gate-on signal or a second off control signal (e.g., a second gate-off voltage) is supplied. In addition, the second gate electrodes of the first to n-th test switching elements TS1 to TSn are connected to an alternating current (AC) voltage line terminal ADT to which a third off control signal (e.g., a third gate-off voltage) swinging within a preset voltage range and having an AC voltage magnitude is supplied.

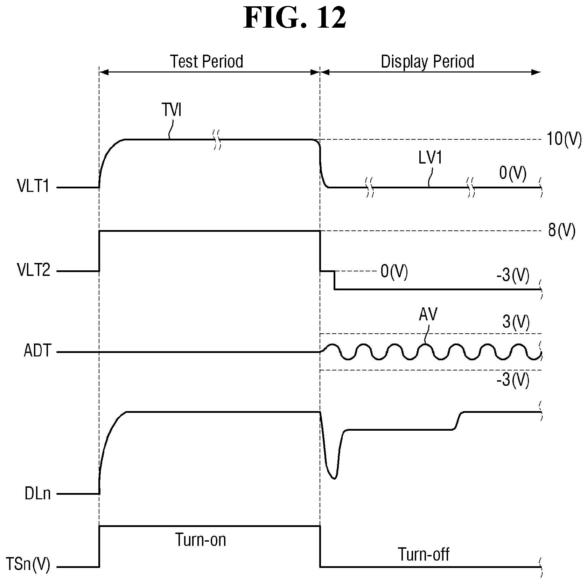

FIG. 12 is a waveform diagram illustrating switching control signals supplied to the test switching elements of FIG. 11 and changes in voltage magnitude of data lines.

During a period when the display panel 100 is commercialized and displays an image, the display driving circuit 200 may maintain the second electrodes of the first to n-th test switching elements TS1 to TS1 in a floating state (e.g., a state of 0 V) through the first line terminal VLT1 of the display panel 100 or supply a first off control signal LV1 (e.g., a first gate-off voltage of 0 V) to the first line terminal VLT1.

The display driving circuit 200 turns off the first to n-th test switching elements TS1 to TSn by supplying a second off control signal (e.g., a second gate-off voltage of -3 V) to the first gate electrodes of the first to n-th test switching elements TS1 to TSn through the second line terminal VLT2 of the display panel 100. Particularly, the display driving circuit 200 may supply the second off control signal (e.g., the second gate-off voltage of -3 V) having a lower voltage magnitude than the first off control signal (e.g., the first gate-off voltage of 0 V) to the first gate electrodes of the first to n-th test switching elements TS1 to TSn.

In addition, the display driving circuit 200 may stably maintain voltages of the first and second gate electrodes so that the voltages of the first and second gate electrodes fluctuate only within a preset range by supplying a third off control signal AV (e.g., a third gate-off voltage swinging in the range of -3 V to 3 V) swinging within a preset voltage range and having an AC voltage magnitude to the second gate electrodes of the first to n-th test switching elements TS1 to TSn.

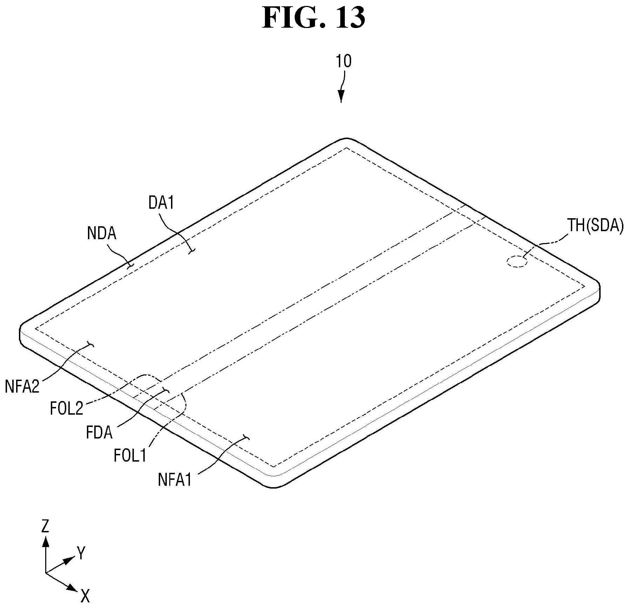

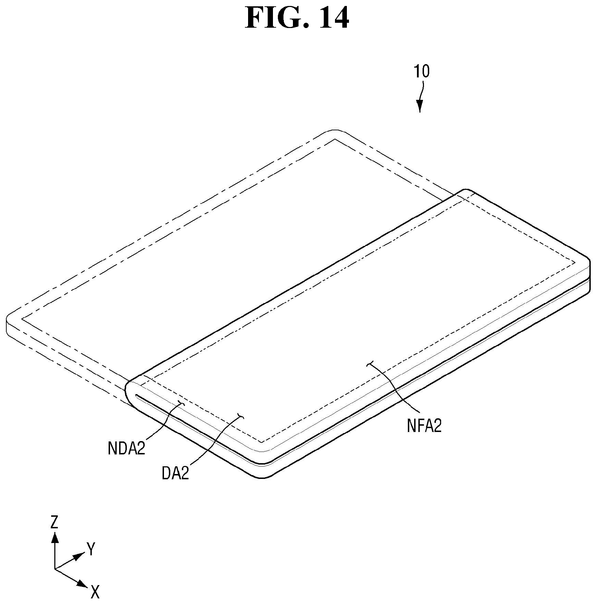

FIGS. 13 and 14 are perspective views illustrating a display device according to another embodiment of the present disclosure.

It has been illustrated in FIGS. 13 and 14 that a display device 10 is a foldable display device folded in the first direction (X-axis direction). The display device 10 may be maintained in both a folded state and an unfolded state. The display device 10 may be folded in an in-folding manner in which a front surface thereof is disposed inside. When the display device 10 is bent or folded in the in-folding manner, front surfaces of the display device 10 may be disposed to face each other. Alternatively, the display device 10 may be folded in an out-folding manner in which a front surface thereof is disposed outside. When the display device 10 is bent or folded in the out-folding manner, rear surfaces of the display device 10 may be disposed to face each other.

A first non-folding area NFA1 may be disposed on one side, for example, the right side, of a folding area FDA. A second non-folding area NFA2 may be disposed on the other side, for example, the left side, of the folding area FDA. The touch sensing units TSU according to an embodiment of the present disclosure may be formed and disposed on the first non-folding area NFA1 and the second non-folding area NFA2, respectively.

A first folding line FOL1 and a second folding line FOL2 may extend in the second direction (Y-axis direction), and the display device 10 may be folded in the first direction (X-axis direction). For this reason, a length of the display device 10 in the first direction (X-axis direction) may be reduced by approximately half, and thus, a user may conveniently carry the display device 10.

Meanwhile, an extension direction of the first folding line FOL1 and an extension direction of the second folding line FOL2 are not limited to the second direction (Y-axis direction). For example, the first folding line FOL1 and the second folding line FOL2 may extend in the first direction (X-axis direction), and the display device 10 may be folded in the second direction (Y-axis direction). In this case, a length of the display device 10 in the second direction (Y-axis direction) may be reduced by approximately half. Alternatively, the first folding line FOL1 and the second folding line FOL2 may extend in a diagonal direction of the display device 10 corresponding to a direction between the first direction (X-axis direction) and the second direction (Y-axis direction). In this case, the display device 10 may be folded in a triangular shape.

When the first folding line FOL1 and the second folding line FOL2 extend in the second direction (Y-axis direction), a length of the folding area FDA in the first direction (X-axis direction) may be smaller than a length of the folding area FDA in the second direction (Y-axis direction). In addition, a length of the first non-folding area NFA1 in the first direction (X-axis direction) may be greater than the length of the folding area FDA in the first direction (X-axis direction). A length of the second non-folding area NFA2 in the first direction (X-axis direction) may be greater than the length of the folding area FDA in the first direction (X-axis direction).

A first display area DA1 may be disposed on a front surface of the display device 10. The first display area DA1 may overlap the folding area FDA, the first non-folding area NFA1, and the second non-folding area NFA2. Therefore, when the display device 10 is unfolded, an image may be displayed in a front surface direction in the folding area FDA, the first non-folding area NFA1, and the second non-folding area NFA2 of the display device 10.

A second display area DA2 may be disposed on a rear surface of the display device 10. The second display area DA2 may overlap the second non-folding area NFA2. Therefore, when the display device 10 is folded, an image may be displayed in a front surface direction in the second non-folding area NFA2 of the display device 10.

It has been illustrated in FIGS. 13 and 14 that a through hole TH in which a camera or the like is formed is disposed in the first non-folding area NFA1, but the present disclosure is not limited thereto. The through hole TH or the camera may be disposed in the second non-folding area NFA2 or the folding area FDA.

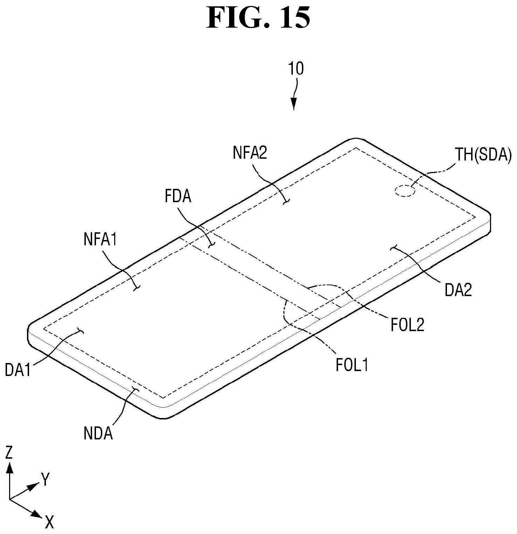

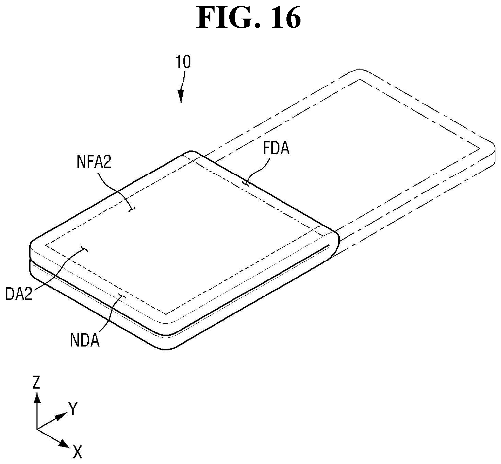

FIGS. 15 and 16 are perspective views illustrating a display device according to still another embodiment of the present disclosure.

It has been illustrated in FIGS. 15 and 16 that a display device 10 is a foldable display device folded in the second direction (Y-axis direction). The display device 10 may be maintained in both a folded state and an unfolded state. The display device 10 may be folded in an in-folding manner in which a front surface thereof is disposed inside. When the display device 10 is bent or folded in the in-folding manner, front surfaces of the display device 10 may be disposed to face each other. Alternatively, the display device 10 may be folded in an out-folding manner in which a front surface thereof is disposed outside. When the display device 10 is bent or folded in the out-folding manner, rear surfaces of the display device 10 may be disposed to face each other.

The display device 10 may include a folding area FDA, a first non-folding area NFA1, and a second non-folding area NFA2. The folding area FDA may be an area where the display device 10 is folded, and the first non-folding area NFA1 and the second non-folding area NFA2 may be areas where the display device 10 is not folded. The first non-folding area NFA1 may be disposed on one side, for example, the lower side, of the folding area FDA. The second non-folding area NFA2 may be disposed on the other side, for example, the upper side, of the folding area FDA.

The touch sensing units TSU according to an embodiment of the present disclosure may be formed and disposed on the first non-folding area NFA1 and the second non-folding area NFA2, respectively.

On the other hand, the folding area FDA may be an area bent with a predetermined curvature in a first folding line FOL1 and a second folding line FOL2. Therefore, the first folding line FOL1 may be a boundary between the folding area FDA and the first non-folding area NFA1, and the second folding line FOL2 may be a boundary between the folding area FDA and the second non-folding area NFA2.

The first folding line FOL1 and the second folding line FOL2 may extend in the first direction (X-axis direction) as illustrated in FIGS. 15 and 16, and the display device 10 may be folded in the second direction (Y-axis direction). For this reason, a length of the display device 10 in the second direction (Y-axis direction) may be reduced by approximately half, and thus, a user may conveniently carry the display device 10.

Meanwhile, an extension direction of the first folding line FOL1 and an extension direction of the second folding line FOL2 are not limited to the first direction (X-axis direction). For example, the first folding line FOL1 and the second folding line FOL2 may extend in the second direction (Y-axis direction), and the display device 10 may be folded in the first direction (X-axis direction). In this case, a length of the display device 10 in the first direction (X-axis direction) may be reduced by approximately half. Alternatively, the first folding line FOL1 and the second folding line FOL2 may extend in a diagonal direction of the display device 10 corresponding to a direction between the first direction (X-axis direction) and the second direction (Y-axis direction). In this case, the display device 10 may be folded in a triangular shape.

When the first folding line FOL1 and the second folding line FOL2 extend in the first direction (X-axis direction) as illustrated in FIGS. 15 and 16, a length of the folding area FDA in the second direction (Y-axis direction) may be smaller than a length of the folding area FDA in the first direction (X-axis direction). In addition, a length of the first non-folding area NFA1 in the second direction (Y-axis direction) may be greater than the length of the folding area FDA in the second direction (Y-axis direction). A length of the second non-folding area NFA2 in the second direction (Y-axis direction) may be greater than the length of the folding area FDA in the second direction (Y-axis direction).

A first display area DA1 may be disposed on a front surface of the display device 10. The first display area DA1 may overlap the folding area FDA, the first non-folding area NFA1, and the second non-folding area NFA2. Therefore, when the display device 10 is unfolded, an image may be displayed in a front surface direction in the folding area FDA, the first non-folding area NFA1, and the second non-folding area NFA2 of the display device 10.

A second display area DA2 may be disposed on a rear surface of the display device 10. The second display area DA2 may overlap the second non-folding area NFA2. Therefore, when the display device 10 is folded, an image may be displayed in a front surface direction in the second non-folding area NFA2 of the display device 10.

It has been illustrated in FIGS. 15 and 16 that a through hole TH in which a camera or the like is disposed is disposed in the second non-folding area NFA2, but the present disclosure is not limited thereto. The through hole TH may be disposed in the first non-folding area NFA1 or the folding area FDA.

In concluding the detailed description, those skilled in the art will appreciate that many variations and modifications can be made to the preferred embodiments without substantially departing from the principles of the present disclosure. Therefore, the disclosed preferred embodiments of the disclosure are used in a generic and descriptive sense only and not for purposes of limitation..

### < Descriptions of Reference Numerals >

| | | | |
|---|---|---|---|
| 10: | display device | 100: | display panel |
| 200: | display driving circuit | 300: | circuit board |
| 400: | touch driving circuit | | |

## Claims

1. A display device comprising:
a plurality of pixels arranged in a display area of a display panel;
a test switching element area formed in a non-display area or a sub-area of the display panel and including a plurality of test switching elements; and
a display driving circuit controlling supply timings of data voltages and driving control signals supplied to the plurality of pixels,
wherein the display driving circuit controls turn-off switching operations of the plurality of test switching elements so that the plurality of test switching elements are maintained in a turn-off state during an image display period.

2. The display device of claim 1, wherein the plurality of test switching elements are connected to a plurality of data lines formed in the display area or a plurality of fan-out lines formed in the non-display area in a one-to-one manner in parallel structures with the plurality of data lines or the plurality of fan-out lines.

3. The display device of claim 2, wherein the plurality of test switching elements are connected to a plurality of gate lines formed in the display area or a plurality of power lines extending to the non-display area in a one-to-one manner in parallel structures with the plurality of gate lines or the plurality of power lines.

4. The display device of claim 2, wherein respective first electrodes formed in the plurality of test switching elements are connected to the plurality of data lines in a one-to-one manner,
respective second electrodes formed in the plurality of test switching elements are connected to at least one first line terminal to which a test direct current (DC) voltage or a first off control signal is supplied, and
respective gate electrodes formed in the plurality of test switching elements are connected to at least one second line terminal to which a gate-on signal or a second off control signal is supplied.

5. The display device of claim 4, wherein the plurality of test switching elements receive the first off control signal supplied to the respective first electrodes during an image display period, and
the plurality of test switching elements are maintained in a turn-off state in response to the second off control signal input to the respective gate electrodes.

6. The display device of claim 4, wherein the display driving circuit maintains the respective second electrodes of the plurality of test switching elements in a floating state through the at least one first line terminal or supplies the first off control signal to the at least one first line terminal, and
the display driving circuit turns off the plurality of test switching elements by supplying the second off control signal to the respective gate electrodes of the plurality of test switching elements through the at least one second line terminal.

7. The display device of claim 6, wherein the display driving circuit turns off the plurality of test switching elements by supplying the second off control signal having a lower voltage magnitude than the first off control signal to the respective gate electrodes of the plurality of test switching elements.

8. The display device of claim 2, wherein respective first electrodes formed in the plurality of test switching elements are connected to the plurality of data lines in a one-to-one manner,
respective second electrodes formed in the plurality of test switching elements are connected to at least one first line terminal to which a test DC voltage or a first off control signal is supplied,
first gate electrodes of respective gate electrodes formed as double layers in the plurality of test switching elements are connected to at least one second line terminal to which a gate-on signal or a second off control signal is supplied, and
second gate electrodes of the respective gate electrodes formed as the double layers in the plurality of test switching elements are connected to a DC voltage line terminal to which a third off control signal having a preset DC voltage magnitude is supplied.

9. The display device of claim 8, wherein the display driving circuit maintains the respective second electrodes of the plurality of test switching elements in a floating state through the at least one first line terminal or supplies the first off control signal to the at least one first line terminal,
the display driving circuit turns off the plurality of test switching elements by supplying the second off control signal to the first respective gate electrodes of the plurality of test switching elements through the at least one second line terminal, and
the display driving circuit turns supplies the third off control signal having the preset DC voltage magnitude to the respective second gate electrodes through the DC voltage line terminal.

10. The display device of claim 9, wherein the display driving circuit turns off the plurality of test switching elements by supplying the second off control signal having a lower voltage magnitude than the first off control signal to the respective first gate electrodes of the plurality of test switching elements.

11. The display device of claim 2, wherein respective first electrodes formed in the plurality of test switching elements are connected to the plurality of data lines in a one-to-one manner,
respective second electrodes formed in the plurality of test switching elements are connected to at least one first line terminal to which a test DC voltage or a first off control signal is supplied,
first gate electrodes of respective gate electrodes formed as double layers in the plurality of test switching elements are connected to at least one second line terminal to which a gate-on signal or a second off control signal is supplied, and
second gate electrodes of the respective gate electrodes formed as the double layers in the plurality of test switching elements are connected to an alternating current (AC) voltage line terminal to which a third off control signal swinging within a preset voltage range and having an AC voltage magnitude is supplied.

12. The display device of claim 11, wherein the display driving circuit maintains the respective second electrodes formed in the plurality of test switching elements in a floating state through the at least one first line terminal or supplies the first off control signal to the at least one first line terminal,
the display driving circuit turns off the plurality of test switching elements by supplying the second off control signal to the first respective gate electrodes formed in the plurality of test switching elements through the at least one second line terminal, and
the display driving circuit turns supplies the third off control signal swinging within the preset voltage range and having the AC voltage magnitude to the respective second gate electrodes through the AC voltage line terminal.

13. A display device comprising:
a plurality of pixels arranged in a display area of a display panel;
a gate driver supplying scan signals to gate lines arranged in a non-display area and the display area of the display panel;
a test switching element area formed in the non-display area or a sub-area of the display panel and including a plurality of test switching elements; and
a display driving circuit controlling supply timings of data voltages and driving control signals supplied to the plurality of pixels and gate control signals supplied to the gate driver,
wherein the display driving circuit controls turn-off switching operations of the plurality of test switching elements so that the plurality of test switching elements are maintained in a turn-off state during an image display period.

14. The display device of claim 13, wherein the plurality of test switching elements are connected to a plurality of data lines formed in the display area or a plurality of fan-out lines formed in the non-display area in a one-to-one manner in parallel structures with the plurality of data lines or the plurality of fan-out lines.

15. The display device of claim 14, wherein the plurality of test switching elements are connected to a plurality of gate lines formed in the display area or a plurality of power lines extending to the non-display area in a one-to-one manner in parallel structures with the plurality of gate lines or the plurality of power lines.

16. The display device of claim 15, wherein respective first electrodes formed in the plurality of test switching elements are connected to the plurality of gate lines in a one-to-one manner,
respective second electrodes formed in the plurality of test switching elements are connected to at least one first line terminal to which a test scan voltage or a first off control signal is supplied, and
respective gate electrodes formed in the plurality of test switching elements are connected to at least one second line terminal to which a gate-on signal or a second off control signal is supplied.

17. The display device of claim 16, wherein the display driving circuit maintains the respective second electrodes formed in the plurality of test switching elements in a floating state through the at least one first line terminal or supplies the first off control signal to the at least one first line terminal, and
the display driving circuit turns off the plurality of test switching elements by supplying the second off control signal to the respective gate electrodes formed in the plurality of test switching elements through the at least one second line terminal.

18. The display device of claim 14, wherein respective first electrodes formed in the plurality of test switching elements are connected to the plurality of data lines in a one-to-one manner,
respective second electrodes formed in the plurality of test switching elements are connected to at least one first line terminal to which a test DC voltage or a first off control signal is supplied, and
respective gate electrodes formed in the plurality of test switching elements are connected to at least one second line terminal to which a gate-on signal or a second off control signal is supplied.

19. The display device of claim 14, wherein respective first electrodes formed in the plurality of test switching elements are connected to the plurality of data lines in a one-to-one manner,
respective second electrodes formed in the plurality of test switching elements are connected to at least one first line terminal to which a test DC voltage or a first off control signal is supplied,
first gate electrodes of respective gate electrodes formed as double layers in the plurality of test switching elements are connected to at least one second line terminal to which a gate-on signal or a second off control signal is supplied, and
second gate electrodes of the respective gate electrodes formed as the double layers in the plurality of test switching elements are connected to a DC voltage line terminal to which a third off control signal having a preset DC voltage magnitude is supplied.

20. The display device of claim 14, wherein respective first electrodes formed in the plurality of test switching elements are connected to the plurality of data lines in a one-to-one manner,
respective second electrodes formed in the plurality of test switching elements are connected to at least one first line terminal to which a test DC voltage or a first off control signal is supplied,
first gate electrodes of respective gate electrodes formed as double layers in the plurality of test switching elements are connected to at least one second line terminal to which a gate-on signal or a second off control signal is supplied, and
second gate electrodes of the respective gate electrodes formed as the double layers in the plurality of test switching elements are connected to an AC voltage line terminal to which a third off control signal swinging within a preset voltage range and having an AC voltage magnitude is supplied.
